# EUROPEAN PATENT APPLICATION

(11) **EP 4 485 131 A1**
(43) Date of publication of application: **01.01.2025**
(21) Application number: 23825869.3
(22) Date of filing: 27.03.2023
(51) Int. Cl.: G06F 1/18

(54) **ELECTRONIC DEVICE AND SERVER**

(30) Priority: 21.06.2022 CN 202210705172
(71) Applicant: xFusion Digital Technologies Co., Ltd., Zhengzhou, Henan 450000 (CN)
(72) Inventor: WANG, Chenglong, Zhengzhou, Henan 450000 (CN); JIA, Hui, Zhengzhou, Henan 450000 (CN)
(74) Representative: MERH-IP Matias Erny Reichl Hoffmann Patentanwälte PartG mbB
(86) International application number: PCT/CN2023/083952
(87) International publication number: WO 2023/246213

(57) **Abstract**

Embodiments of this application provide an electronic device and a server. The electronic device includes a housing, a hose, a mounting bracket, a sealing structure, a floating structure, and a first connector. A working medium through-flow hole is disposed on the housing, one end of the hose is located in the housing through the working medium through-flow hole, and the other end of the hose is located outside the housing and is in communication with the first connector. The hose is fixedly connected to the housing at the working medium through-flow hole by using the sealing structure, and the sealing structure seals a gap between the hose and the housing. The mounting bracket is located on an outer side of the housing, one end of the mounting bracket is fixedly connected to the housing, the floating structure is mounted on the other end of the mounting bracket, and the first connector is mounted on the floating structure. The floating structure is movably connected to the mounting bracket, and/or the first connector is movably connected to the floating structure. In the electronic device and the server provided in the embodiments of this application, sealing at the working medium through-flow hole on the housing of the electronic device is convenient, and a requirement for position precision of a connector at the working medium through-flow hole can be reduced.

## Description

This application claims priority to Chinese Patent Application No. 202210705172.3, filed with the China National Intellectual Property Administration on June 21, 2022 and entitled "ELECTRONIC DEVICE AND SERVER", which is incorporated herein by reference in its entirety.

### TECHNICAL FIELD

Embodiments of this application relate to the field of electronic device technologies, and in particular, to an electronic device and a server.

### BACKGROUND

With high-speed development of the information and communication technology industry, a device integration degree and thermal density of a data center are increasingly high, and a requirement for heat dissipation is also increasingly high. A conventional heat dissipation manner of an air-cooled combined air conditioner causes power usage effectiveness (Power Usage Effectiveness, PUE) of the data center to be high, and the conventional heat dissipation manner gradually fails to meet a requirement of the data center.

The data center includes a server disposed in an equipment room. The server includes a chassis and an electronic device assembled in the chassis. Heat generated by an electronic component in the electronic device raises the temperature of the data center. To enhance heat dissipation performance of the data center, heat dissipation may be performed, in the electronic device in a immersion liquid cooling manner, on the electronic component that emits heat. In a related technology, some electronic devices on which heat dissipation is performed in an immersion liquid cooling manner each includes a housing and an electronic component disposed in the housing. The housing accommodates a cooling working medium used for immersion cooling of the electronic component. Some working medium through-flow holes for the cooling working medium to flow in and out are disposed on the housing. A first connector is fixedly connected to a working medium through-flow hole. The first connector is hermetically connected to the housing at the corresponding working medium through-flow hole, and the first connector at the working medium through-flow hole is configured to butt-joint to a corresponding second connector on a working medium cooling system, so that a liquid cooling medium flowing out from the housing is cooled by the working medium cooling system and then flows back to the housing. However, to stably and reliably assemble the electronic device and the working medium cooling system, in the electronic device in the related technology, a requirement for position precision of the connectors at the working medium through-flow holes is high.

Therefore, on a premise of stably and reliably assembling the electronic device and the working medium cooling system, how to perform sealing at the working medium through-flow holes and reduce the requirement for the position precision of the connectors at the working medium through-flow holes becomes a problem to be resolved urgently.

### SUMMARY

Embodiments of this application provide an electronic device and a server. An inner cavity of a housing is in communication with a first connector through a hose passing through the housing. Sealing is implemented between the hose and the housing by using a sealing structure. The first connector is mounted on the housing by using a floating structure on a mounting bracket. Sealing at a working medium through-flow hole is convenient. On a premise of stably and reliably assembling the electronic device and a working medium cooling system, a requirement for position precision of a connector at the working medium through-flow hole can be reduced.

According to a first aspect of the embodiments of this application, an electronic device is provided, including a housing, a hose, a mounting bracket, a sealing structure, a floating structure, and a first connector. A working medium through-flow hole is disposed on the housing, one end of the hose is located in the housing through the working medium through-flow hole, and the other end of the hose is located outside the housing and is in communication with the first connector. The hose is fixedly connected to the housing at the working medium through-flow hole by using the sealing structure, and the sealing structure seals a gap between the hose and the housing. The mounting bracket is located on an outer side of the housing, one end of the mounting bracket is fixedly connected to the housing, the floating structure is mounted on the other end of the mounting bracket, and the first connector is mounted on the floating structure. The floating structure is movably connected to the mounting bracket, and/or the first connector is movably connected to the floating structure.

In the electronic device provided in the embodiments of this application, an inner cavity of the housing is in communication with the first connector through the hose, and sealing is implemented between the hose and the housing by using the sealing structure. In this way, sealing between the hose and the housing is convenient. The first connector is mounted on the housing by using the floating structure on the mounting bracket. The first connector is movable relative to the housing. A part that is of the hose and that is between the housing and the floating structure can perform activities such as stretching and bending. The movable hose between the floating structure and the housing has a long length. In this way, a gap between the floating structure and the housing can be narrowed or a floating amount of the floating structure can be increased, thereby facilitating arrangement of the floating structure and reducing space occupation. In addition, the housing may have a simpler structure and may be easier to manufacture. When the first connector is connected to a corresponding second connector on the working medium cooling system, even if a position of the first connector relative to the corresponding second connector on the working medium cooling system deviates, the position of the first connector may also be adjusted by using the floating structure, so that the first connector is stably and reliably connected to the corresponding second connector. In this way, on a premise of stably and reliably assembling the electronic device and the working medium cooling system, sealing of the housing at the working medium through-flow hole is convenient, and a requirement for position precision of the first connector is low. Therefore, a requirement for disposition position precision of the first connector on the electronic device can be reduced, and a requirement for assembly position precision of the electronic device relative to the second connector can be reduced.

In a possible implementation, the sealing structure includes a plug, the plug is disposed at the working medium through-flow hole, the plug is fixedly connected to the housing, the hose penetrates through the plug and is fixedly connected to the plug, a joint between the hose and the plug is sealed, and the plug seals a gap between the hose and the housing.

In a possible implementation, the plug and the hose are of an integrated structure.

In a possible implementation, the plug includes a plugging part, the plugging part extends into the working medium through-flow hole, the hose penetrates through the plugging part and is fixedly connected to the plugging part, a joint between the hose and the plugging part is sealed, and the plugging part seals a gap between the hose and a hole wall of the working medium through-flow hole.

In a possible implementation, the hole wall of the working medium through-flow hole has a step structure, and the plugging part abuts against the step structure of the working medium through-flow hole, to limit movement of the plugging part towards a direction of an inner cavity of the housing.

In a possible implementation, the step structure of the working medium through-flow hole has at least one first vertical end face. The sealing structure further includes a sealing gasket disposed between the at least one first vertical end face and the plugging part, the first vertical end face at the sealing gasket abuts against the plugging part by using the sealing gasket, and the sealing gasket seals a gap between the first vertical end face at the sealing gasket and the plugging part, so that the plugging part seals the gap between the hose and the hole wall of the working medium through-flow hole.

In a possible implementation, the step structure of the working medium through-flow hole has at least one first horizontal sidewall. The sealing structure further includes a sealing ring disposed between the at least one first horizontal sidewall and the plugging part, and the sealing ring seals a gap between the first horizontal sidewall at the sealing ring and the plugging part, so that the plugging part seals the gap between the hose and the hole wall of the working medium through-flow hole.

In a possible implementation, the plug further includes a limiting part disposed on an outer wall of the plugging part, the hose penetrates through the limiting part and is fixedly connected to the limiting part, and a joint between the hose and the limiting part is sealed. An end face that is of the limiting part and that faces the inner cavity of the housing abuts against the housing, to limit movement of the plugging part towards the direction of the inner cavity of the housing.

In a possible implementation, the plug further includes a guide part, the guide part is disposed coaxially with the plugging part, one end that is of the plugging part and that faces the inner cavity of the housing is fixedly connected to one end of the guide part, and the other end of the guide part extends into the housing through the working medium through-flow hole. The hose penetrates through the guide part and is fixedly connected to the guide part, and a joint between the hose and the guide part is sealed.

In a possible implementation, the sealing structure further includes a compression flange. The compression flange is fixedly connected to an outer wall of the housing by using a fastener, and the compression flange abuts against an end face of one end that is of the plug and that faces away from the inner cavity of the housing, to compress and fasten the plug on the housing.

In a possible implementation, the first connector includes a first end, a mounting part, and a second end that are in communication with each other, and the mounting part is located between the first end and the second end. The floating structure includes a mounting seat and an elastic adjustment sleeve, the mounting seat is mounted on the mounting bracket, a mounting groove is disposed on an end face that is of the mounting seat and that faces away from the housing, a communication hole penetrating through the mounting seat is disposed on a groove wall that is of the mounting groove and that is opposite to a groove opening, the mounting part is disposed in the mounting groove, the first end extends into the communication hole and is connected to the hose, and the second end is configured to connect to a working medium cooling system. The elastic adjustment sleeve is disposed between a sidewall of the mounting part and the groove wall of the mounting groove, the mounting part is mounted in the mounting groove through the elastic adjustment sleeve, and the elastic adjustment sleeve is configured to be deformed under the action of an external force, so that a position of the second end changes.

In a possible implementation, a guide post that is oriented in an axial direction of the working medium through-flow hole is fixedly connected to the mounting bracket, a sliding hole that is in sliding engagement with the guide post is disposed on the mounting seat, and the mounting seat is slidably connected to the mounting bracket by using the guide post and the sliding hole. An elastic reset member is further disposed between the mounting bracket and the mounting seat, and the elastic reset member is configured to reset the mounting seat.

According to a second aspect of the embodiments of this application, a server is provided, including at least one electronic device according to any one of the foregoing implementations.

In a possible implementation, the server further includes a working medium cooling system. A second connector that is in a one-to-one correspondence with a first connector of the electronic device is disposed on the working medium cooling system, the first connector is butt-jointed to the corresponding second connector, and the second connector is in communication with the working medium cooling system. The second connector is used by the working medium cooling system to input a cooling working medium to the electronic device through the first connector, or the second connector is used by the electronic device to output a cooling working medium to the working medium cooling system through the first connector.

With reference to the accompanying drawings, these and other aspects, implementation forms, and advantages of example embodiments become apparent from the embodiments described below. It should be understood, however, that the specification and the accompanying drawings are merely intended to illustrate and are not intended to limit the embodiments of this application. For details, refer to the appended claims. Other aspects and advantages of the embodiments of this application are described in the following descriptions, and some of them are obvious from the descriptions, or are learned from practice of the embodiments of this application. In addition, aspects and advantages of the embodiments of this application may be implemented and obtained by using means and combinations specifically noted in the appended claims.

### BRIEF DESCRIPTION OF DRAWINGS

FIG. 1 is a schematic diagram of a data center according to an embodiment of this application;
FIG. 2 is a schematic diagram of a server according to an embodiment of this application;
FIG. 3 is a schematic diagram of a connection between an electronic device and a working medium cooling system according to an embodiment of this application;
FIG. 4 is a schematic diagram of a partial structure of an electronic device according to an embodiment of this application.
FIG. 5 is a cross-sectional view of a working medium through-flow hole of an electronic device according to an embodiment of this application;
FIG. 6 is an exploded view of an assembly part between a floating structure and a mounting bracket of an electronic device according to an embodiment of this application;
FIG. 7 is an enlarged view of a part B in FIG. 6;
FIG. 8 is a cross-sectional view of a guide post of an electronic device according to an embodiment of this application;
FIG. 9 is an enlarged view of a part A in FIG. 5; and
FIG. 10 is an exploded view of a hose, a plug, a sealing ring, a sealing gasket, and a compression flange of an electronic device according to an embodiment of this application.

Descriptions of reference numerals:
100-data center; 110-server; 111-electronic device; 112-chassis; 113-working medium cooling system; 114-second connector; 120-equipment room;
200-housing; 210-working medium through-flow hole; 220-electronic component;
300-hose;
400-mounting bracket; 410-limiting flange; 411-second opening; 412-convex ring; 420-mounting plate; 421-first opening; 430-first support plate; 440-second support plate;
500-first connector; 510-second end; 520-first end; 530-mounting part;
600-sealing structure; 610-plug; 611-plugging part; 612-limiting part; 613-guide part; 620-compression flange; 621-base plate part; 622-boss part; 631-sealing gasket; 632-sealing ring;
700-floating structure; 710-mounting seat; 711-mounting groove; 712-sliding hole; 713-reset member mounting hole; 720-elastic adjustment sleeve; 730-abutment seat; 740-guide post; and 750-reset spring.

### DESCRIPTION OF EMBODIMENTS

The terms used in the implementation part of this application are merely used to explain specific embodiments of this application, and are not intended to limit this application. The following describes the implementations of the embodiments of this application in detail with reference to the accompanying drawings.

Internet service providers, enterprise platforms, research institutes, and the like all have a large quantity of computing requirements. A work platform that bears requirements such as storage, computing, and networking is referred to as a data center.

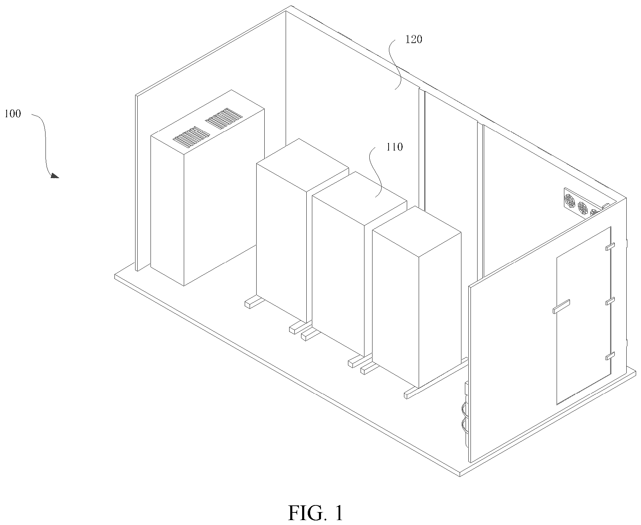

FIG. 1 is a schematic diagram of a data center according to an embodiment of this application.

As shown in FIG. 1, a data center 100 provided in this embodiment of this application may include an equipment room 120 and at least one server 110 disposed in the equipment room 120. It should be noted that the equipment room 120 may be a closed room or a room with one or more sides opened, may be a built temporary room, for example, a tent room or a prefabricated room, or may be a built permanent room.

It may be understood that only one server 110 or a plurality of servers 110 may be disposed in the equipment room 120. When a plurality of servers 110 are disposed in the equipment room 120, the servers 110 may be the same, partially the same, or different.

The server 110 provided in this embodiment of this application may be of various types, such as a desktop server, a blade server, a rack server, or a cabinet server.

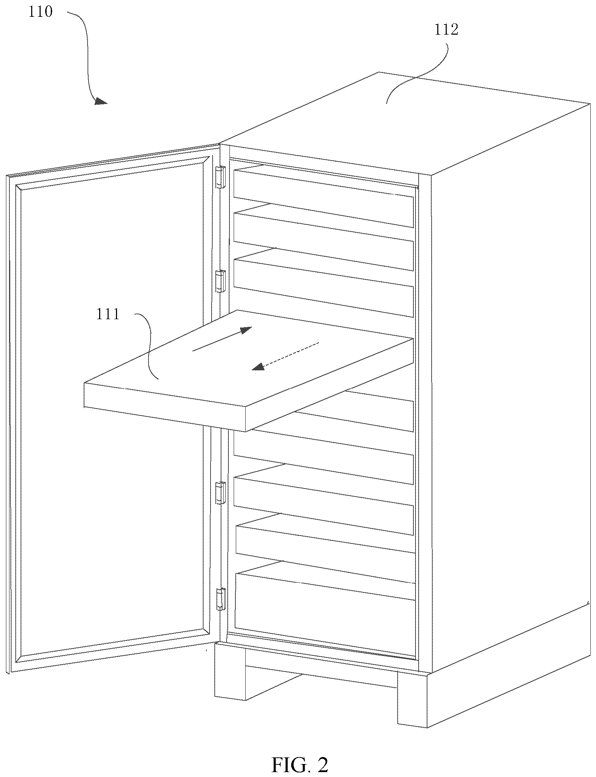

FIG. 2 is a schematic diagram of a server according to an embodiment of this application.

As shown in FIG. 2, the server 110 provided in this embodiment of this application may include a chassis 112 and at least one electronic device 111 mounted in the chassis 112. It may be understood that only one electronic device 111 or a plurality of electronic devices 111 may be mounted in the chassis 112. The electronic device 111 in the chassis 112 may be horizontally, vertically, or obliquely disposed. When a plurality of electronic devices 111 are mounted in the chassis 112, the electronic devices 111 may be the same, partially the same, or different.

A mounting structure for mounting the electronic device 111 may be further disposed in the chassis 112, and the electronic device 111 may be mounted in the chassis 112 by using the mounting structure. For example, the mounting structure may be a fastener structure, a bolt, or the like.

The electronic device 111 provided in this embodiment of this application may include but is not limited to a computing device, a storage device, or a communication device. For example, the electronic device 111 may be a calculator, a memory, a switch, or the like. For example, the electronic device 111 may be a computing node used for the server 110. In this embodiment of this application, a blade-type computing node is used as an example to describe the electronic device 111.

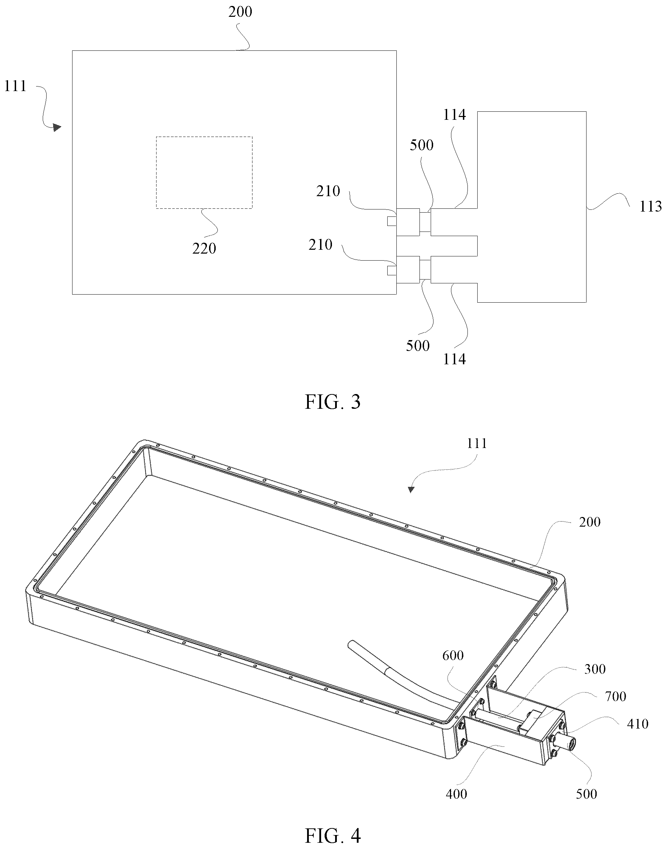

FIG. 3 is a schematic diagram of a connection between an electronic device and a working medium cooling system according to an embodiment of this application.

As shown in FIG. 3, to improve an indicator of power usage effectiveness of the data center 100, the server 110 provided in this embodiment of this application may further include a working medium cooling system 113. The working medium cooling system 113 may be disposed in the chassis 112, and the working medium cooling system 113 is configured to cool a medium entering the working medium cooling system 113. It may be understood that the working medium cooling system 113 may be fastened to an inner wall of the chassis 112, and the working medium cooling system 113 may be a condenser or another device.

The electronic device 111 may include a housing 200 and an electronic component 220 disposed in the housing 200. The housing 200 may accommodate a cooling working medium used for immersion cooling of the electronic component 220. The cooling working medium may be fluoride, silicone oil, or another non-conductive coolant. The electronic component 220 is at least partially immersed in the cooling working medium. The cooling working medium may absorb heat emitted by the electronic component 220, to reduce a temperature of the electronic component 220.

Two working medium through-flow holes 210 are disposed on the housing 200, one of the working medium through-flow holes 210 is in communication with an input end of the working medium cooling system 113, and the other working medium through-flow hole 210 is in communication with an output end of the working medium cooling system 113, so that the cooling working medium that absorbs the heat emitted by the electronic component 220 flows out from the working medium through-flow hole 210 in communication with the input end of the working medium cooling system 113. The cooling working medium flowing out of the housing 200 carries out the heat absorbed from the housing 200, and then flows back to the housing 200 through the other working medium through-flow hole 210 after being cooled and heat-dissipated heat by the working medium cooling system 113.

It should be noted that the cooling working medium accommodated in the housing 200 may be a single-phase liquid cooling working medium or a two-phase liquid cooling working medium. When the cooling working medium accommodated in the housing 200 is a two-phase liquid cooling working medium, the cooling working medium absorbs the heat emitted by the electronic component 220 and changes into a gaseous state. The gaseous cooling working medium flows out of the housing 200 and enters the working medium cooling system 113. After passing through the working medium cooling system 113 and being cooled into a liquid state, the cooling working medium flows back to the housing 200.

To implement a connection between the working medium through-flow hole 210 and the working medium cooling system 113, a first connector 500 may be disposed at a working medium through-flow hole 210, a second connector 114 corresponding to the first connector 500 may be disposed on the working medium cooling system 113, the second connector 114 is in communication with the working medium cooling system 113, and the first connector 500 is butt-jointed to the corresponding second connector 114, so that an inner cavity of the housing 200 is in communication with the working medium cooling system 113.

It may be understood that each of the two working medium through-flow holes 210 of the housing 200 may be disposed with the first connector 500, and each of the input end and the output end of the working medium cooling system 113 may also be disposed with the corresponding second connector 114. The first connector 500 at one of the working medium through-flow holes 210 is butt-jointed to the second connector 114 at the input end of the working medium cooling system 113, and the first connector 500 at the other working medium through-flow hole 210 is butt-jointed to the second connector 114 at the output end of the working medium cooling system 113.

The second connector 114 is used by the working medium cooling system 113 to input the cooling working medium to the electronic device 111 through the first connector 500, or the second connector 114 is used by the electronic device 111 to output the cooling working medium to the working medium cooling system 113 through the first connector 500. Specifically, the second connector 114 disposed at the output end of the working medium cooling system 113 is used by the working medium cooling system 113 to input the cooling working medium to the housing 200 of the electronic device 111 through the first connector 500, and the second connector 114 disposed at the input end of the working medium cooling system 113 is used by the housing 200 of the electronic device 111 to output the cooling working medium to the working medium cooling system 113 through the first connector 500.

For example, for ease of assembly, the second connector 114 of the working medium cooling system 113 may be disposed on a backplane of the chassis 112. After the electronic device 111 is mounted in the chassis 112, the first connector 500 at the working medium through-flow hole 210 may be butt-jointed to the corresponding second connector 114 on the backplane.

However, in an electronic device of a related technology, to facilitate sealing at the working medium through-flow hole, the first connector is fixedly connected to the working medium through-flow hole of the housing, and implements sealing with the housing at the working medium through-flow hole. Because the first connector is fastened to the housing and the second connector is fastened in the chassis, after the electronic device is assembled in the chassis, the first connector and the corresponding second connector need to be directly opposite to each other to be stably and reliably butt-jointed. Even if the first connector is a blind-mating connector, the floating angle and displacement of the blind-mating connector are extremely limited. If there is a slight misalignment between the first connector and its corresponding second connector, the first connector may not be successfully connected to the corresponding second connector, or result in poor reliability and stability after the first connector is connected to the corresponding second connector. Therefore, in the electronic device in the related technology, a requirement for position precision of the first connector is high. In this case, a requirement for disposition position precision of the first connector on the electronic device is high, and a requirement for assembly position precision of the electronic device relative to the second connector is also high.

The following describes, by using a specific embodiment, an implementation of the electronic device provided in the embodiments of this application.

FIG. 4 is a schematic diagram of a partial structure of an electronic device according to an embodiment of this application. FIG. 4 is merely a schematic diagram of assembly of a first connector 500 at a working medium through-flow hole 210 on a housing 200. The first connector 500 may also be assembled at another working medium through-flow hole 210 on the housing 200 in a same manner.

As shown in FIG. 4, an electronic device 111 provided in this embodiment of this application may include a housing 200, a hose 300, a mounting bracket 400, a sealing structure 600, a floating structure 700, and a first connector 500.

A working medium through-flow hole 210 is disposed on the housing 200, one end of the hose 300 is located in the housing 200 through the working medium through-flow hole 210, and the other end of the hose 300 is located outside the housing and is in communication with the first connector 500. The hose 300 is fixedly connected to the housing 200 at the working medium through-flow hole 210 by using the sealing structure 600, and the sealing structure 600 seals a gap between the hose 300 and the housing 200.

It may be understood that the first connector 500 is configured to connect to a corresponding second connector 114 of a working medium cooling system 113, so that the working medium cooling system 113 is in communication with an inner cavity of the housing 200 through the second connector 114, the first connector 500, and the hose 300.

It should be noted that the hose 300 penetrates into the housing 200 and is in communication with the inner cavity of the housing 200, and the sealing structure 600 seals the gap between an outer wall of the hose 300 and the housing 200. In this way, sealing at the working medium through-flow hole 210 is convenient. Apart that is of the hose 300 and that is between the housing 200 and the floating structure 700 may perform activities such as stretching and bending. The movable part of the hose 300 between the floating structure 700 and the housing 200 has a long length. In this way, a gap between the floating structure 700 and the housing 200 can be narrowed or a floating amount of the floating structure 700 can be increased, thereby facilitating arrangement of the floating structure 700 and reducing space occupation. In addition, the housing 200 may have a simpler structure and may be easier to manufacture.

In this embodiment of this application, the mounting bracket 400 is located on an outer side of the housing 200, one end of the mounting bracket 400 is fixedly connected to the housing 200, the floating structure 700 is mounted on the other end of the mounting bracket 400, and the first connector 500 is mounted on the floating structure 700. The floating structure 700 is movably connected to the mounting bracket 400, and/or the first connector 500 is movably connected to the floating structure 700.

It should be noted that the floating structure 700 may be fixedly connected to the mounting bracket 400, and the first connector 500 is movably connected to the floating structure 700; the floating structure 700 may be movably connected to the mounting bracket 400, and the first connector 500 is fixedly connected to the floating structure 700; or the floating structure 700 may be movably connected to the mounting bracket 400, and the first connector 500 is also movably connected to the floating structure 700.

It may be understood that after the first connector 500 is mounted on the floating structure 700 and the floating structure 700 is mounted on the mounting bracket 400, the first connector 500 may move relative to the mounting bracket 400 and the housing 200. Specifically, the first connector 500 may slide and/or rotate and/or swing and/or the like relative to the mounting bracket 400.

In this way, when the electronic device 111 is assembled with the working medium cooling system 113, even if a position of the first connector 500 relative to the corresponding second connector 114 deviates, the position of the first connector 500 may also be adjusted by using the floating structure 700 to stably and reliably connect the first connector 500 to the corresponding second connector 114. After the first connector 500 is connected to the second connector 114 of the working medium cooling system 113, the inner cavity of the housing 200 is in communication with an inner cavity of the working medium cooling system 113, and sealing between the hose 300 and the housing is implemented by using the sealing structure 600. In this way, on a premise of stably and reliably assembling the electronic device 111 and the working medium cooling system 113, sealing of the housing 200 at the working medium through-flow hole 210 is convenient, and a requirement for position precision of the first connector 500 is low. Therefore, a requirement for disposition position precision of the first connector 500 on the electronic device 111 can be reduced, and a requirement for assembly position precision of the electronic device 111 relative to the second connector 114 can be reduced.

It should be noted that, to increase a floating amount of the first connector 500, the first connector 500 may be a movable blind-mating connector. Certainly, to save costs, the first connector 500 may alternatively be a connector that is not movable. In this way, selections of the first connector 500 can be more diversified.

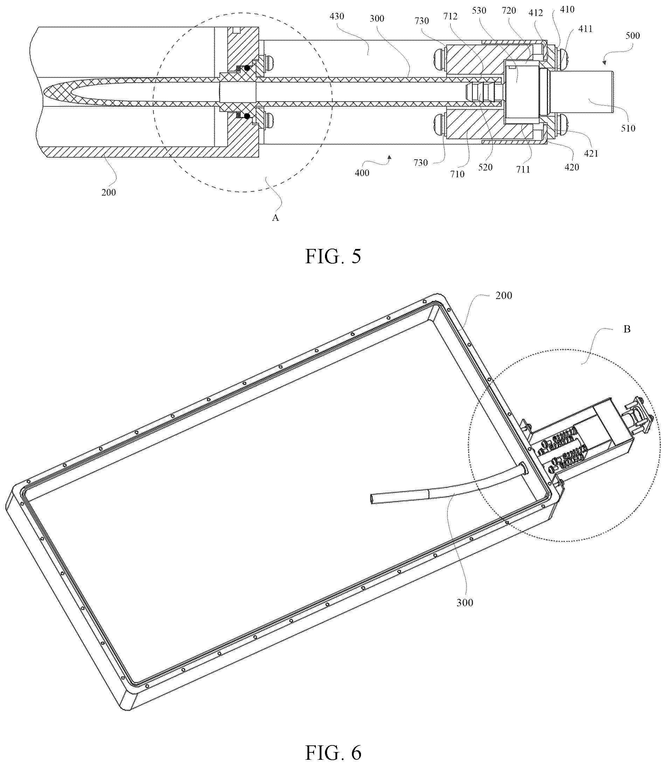

FIG. 5 is a cross-sectional view of a working medium through-flow hole of an electronic device according to an embodiment of this application.

As shown in FIG. 5, in this embodiment of this application, the first connector 500 includes a first end 520 and a second end 510 that are in communication with each other, the first end 520 is in communication with an end part of the hose 300, and the second end 510 is configured to connect to the working medium cooling system 113. Specifically, the second end 510 is configured to connect to the corresponding second connector 114 of the working medium cooling system 113.

It may be understood that after the second end 510 is connected to the corresponding second connector 114 of the working medium cooling system 113, the first connector 500 may be in communication with the working medium cooling system 113.

In this embodiment of this application, the floating structure 700 includes a mounting seat 710, the mounting seat 710 is mounted on the mounting bracket 400, a mounting groove 711 is disposed on an end face that is of the mounting seat 710 and that faces away from the housing 200. A communication hole penetrating through the mounting seat 710 is disposed on a groove wall that is of the mounting groove 711 and that is opposite to a groove opening. The first connector 500 further includes a mounting part 530 that is located between the first end 520 and the second end 510. Two ends of the mounting part 530 are respectively in communication with the first end 520 and the second end 510. The mounting part 530 is disposed in the mounting groove 711, and the first end 520 extends into the communication hole and is connected to the hose 300.

It may be understood that the first end 520 may be connected to the hose 300 in or out of the communication hole.

In this embodiment of this application, the floating structure 700 further includes an elastic adjustment sleeve 720. The elastic adjustment sleeve 720 is disposed between a sidewall of the mounting part 530 and the groove wall of the mounting groove 711. The mounting part 530 is mounted in the mounting groove 711 through the elastic adjustment sleeve 720. The elastic adjustment sleeve 720 is configured to be deformed under the action of an external force, to change the position of the second end 510.

It should be noted that the elastic adjustment sleeve 720 is sleeved outside the mounting part 530 to tightly clamp the mounting part 530. Under the action of the external force, the second end 510 may enable the mounting part 530 to compress the elastic adjustment sleeve 720 to deform the elastic adjustment sleeve 720, to change the position of the second end 510.

It may be understood that the elastic adjustment sleeve 720 may be made of silicone, rubber, or another elastic material, and the elastic adjustment sleeve 720 may further provide an elastic restoring force for resetting the first connector 500. After the mounting part 530 is mounted in the mounting groove 711 through the elastic adjustment sleeve 720, the second end 510 and the mounting part 530 form a rocker structure with the mounting seat 710, and the second end 510 may swing in any direction perpendicular to an axial direction of the elastic adjustment sleeve 720.

In this way, the second end 510 of the first connector 500 may swing relative to the housing 200 in any radial direction of the elastic adjustment sleeve 720. After the electronic device 111 is fastened in the chassis 112, a relative distance between the second end 510 of the first connector 500 and the second connector 114 corresponding to the first connector 500 may be changed in the direction perpendicular to the axial direction of the elastic adjustment sleeve 720, so that the second end 510 of the first connector 500 and the second connector 114 corresponding to the first connector 500 can be stably and reliably connected when deviating from each other in the direction perpendicular to the axial direction of the elastic adjustment sleeve 720.

In some examples, the mounting part 530 is of a cylindrical structure, and a cross section of the mounting groove 711 in a direction perpendicular to an axial direction of the mounting part 530 is circular. This facilitates the mounting part 530 to drive the second end 510 to swing in various directions perpendicular to the axial direction of the elastic adjustment sleeve 720.

In some examples, the second end 510, the first end 520, and the mounting part 530 are coaxially disposed.

This is conducive to reducing a size of the mounting seat 710.

In some examples, the first end 520 is connected to the hose 300 in the communication hole, and the hose 300 extends into the communication hole.

In this way, the communication hole can play a role of limiting some movementof the hose 300, and the hose 300 is firmer after being connected to the first end 520.

In some examples, a limiting flange 410 is further disposed on the mounting bracket 400, and the limiting flange 410 is fixedly connected to one side that is of the mounting bracket 400 and that faces away from the housing 200. A first opening 421 is disposed on the mounting bracket 400. The first opening 421 is used for the second end 510 of the first connector 500 to pass through and can be used for the second end 510 to move. A second opening 411 that is used for the second end 510 to pass through and that can be used for the second end 510 to move is disposed on the limiting flange 410. A convex ring 412 extending in a direction towards the housing 200 is disposed on an edge of the second opening 411. The convex ring 412 passes through the first opening 421 on the mounting bracket 400. One end that is of the convex ring 412 and that faces the housing 200 is configured to abut against the elastic adjustment sleeve 720 and the mounting part 530, to prevent the elastic adjustment sleeve 720 and the mounting part 530 from being detached from the mounting groove 711.

In this way, the mounting part 530 and the elastic adjustment sleeve 720 can be assembled in the mounting groove 711 more firmly.

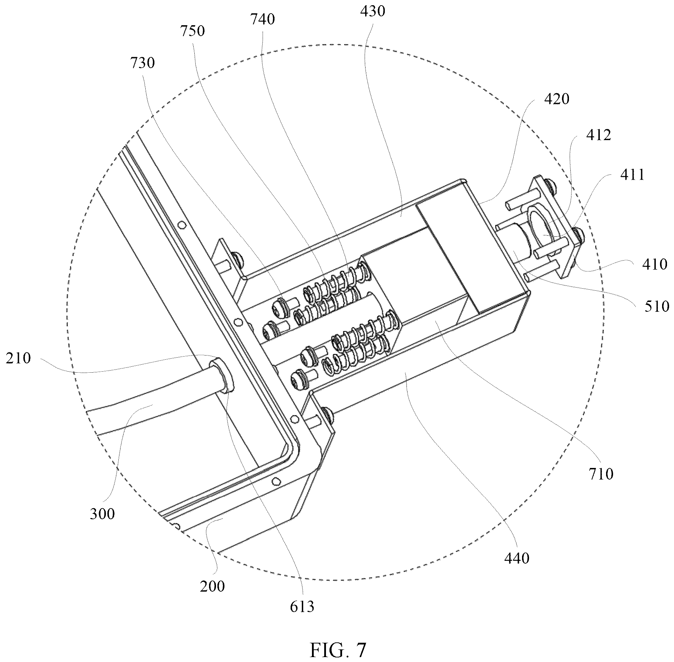

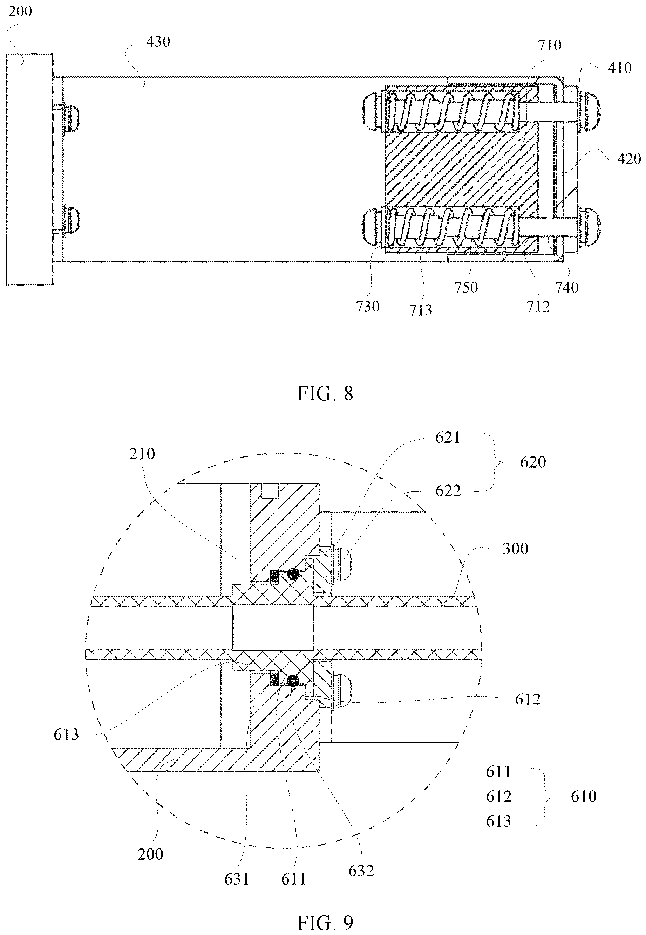

FIG. 6 is an exploded view of an assembly part between a floating structure and a mounting bracket of an electronic device according to an embodiment of this application. FIG. 7 is an enlarged view of a part B in FIG. 6. FIG. 8 is a cross-sectional view of a guide post of an electronic device according to an embodiment of this application.

As shown in FIG. 6 to FIG. 8, in this embodiment of this application, the mounting seat 710 of the floating structure 700 may be slidably mounted on the mounting bracket 400, the mounting seat 710 may slide relative to the mounting bracket 400 in an axial direction of the working medium through-flow hole 210, and the first connector 500 is mounted on the mounting seat 710.

In this way, the second end 510 of the first connector 500 can move relative to the housing 200 in the axial direction of the working medium through-flow hole 210. After the electronic device 111 is fastened in the chassis 112, a relative distance between the second end 510 of the first connector 500 and the second connector 114 corresponding to the first connector 500 can be changed in the axial direction of the working medium through-flow hole 210, so that the second end 510 of the first connector 500 and the second connector 114 corresponding to the first connector 500 can be stably and reliably connected when the relative distance between the second end 510 of the first connector 500 and the second connector 114 corresponding to the first connector 500 is large or small in the axial direction of the working medium through-flow hole 210.

It may be understood that when the mounting seat 500 is slidably mounted on the mounting bracket 400, the first connector 500 may be fastened to the mounting seat 710, or may be movably mounted on the mounting seat 710.

For example, the mounting seat 500 is slidably mounted on the mounting bracket 400, and the first connector 500 is movably mounted on the mounting seat 710 through the elastic adjustment sleeve 720.

In this embodiment of this application, a guide post 740 that is oriented in the axial direction of the working medium through-flow hole 210 is fixedly connected to the mounting bracket 400, a sliding hole 712 that is in sliding engagement with the guide post 740 is disposed on the mounting seat 710, and the mounting seat 710 is slidably connected to the mounting bracket 400 by using the guide post 740 and the sliding hole 712. It may be understood that the sliding hole 712 is a through hole.

This facilitates the mounting seat 710 to stably slide relative to the mounting bracket 400.

To enable the mounting seat 710 to more stably slide, a plurality of guide posts 740 may be disposed on the mounting bracket 400, and a plurality of sliding holes 712 that are in a one-to-one correspondence with the guide posts 740 may be disposed on the mounting seat 710.

In this embodiment of this application, an elastic reset member is further disposed between the mounting bracket 400 and the mounting seat 710, and the elastic reset member is configured to reset the mounting seat 710.

It may be understood that the mounting seat 710 may slide relative to the mounting bracket 400 under the action of an external force. After the external force acting on the mounting seat 710 disappears, the elastic reset member may restore the mounting seat 710 to an initial position.

In this way, a risk that difficulty of assembling the first connector 500 and the corresponding second connector 114 is increased because the first connector 500 moves to a position close to the housing 200 can be reduced.

In this embodiment of this application, a reset member mounting hole 713 is disposed on an end face that is of the mounting seat 710 and that faces the housing 200, the reset member mounting hole 713 is a blind hole, and the sliding hole 712 is disposed on a hole bottom of the reset member mounting hole 713. An abutment seat 730 that is in sliding engagement with the reset member mounting hole 713 is disposed on one end that is of the guide post 740 and that faces the housing 200. The elastic reset member is a reset spring 750 disposed in the reset member mounting hole 713. The reset spring 750 is disposed between the abutment seat 730 and the hole bottom of the reset member mounting hole 713. The reset spring 750 is coaxially sleeved on an outer side of the guide post 740. Both ends of the reset spring 750 are respectively configured to abut against the abutment seat 730 and the hole bottom of the reset member mounting hole 713.

It should be noted that one end that is of the guide post 740 and that faces away from the housing 200 may be connected or fastened to the mounting bracket 400 by using a fastener or in an integration manner. The abutment seat 730 may be connected or fastened to the end that is of the guide post 740 and that faces the housing 200 by using a fastener or in an integration manner.

In an example in which the limiting flange 410 is fixedly connected to the mounting bracket 400 by using the fastener, the limiting flange 410 may be fixedly connected to the mounting bracket 400 by using a fastener fixedly connected to the guide post 740.

In this way, requirements for fasteners can be reduced, and a space required by the fasteners can be narrowed.

In this embodiment of this application, the mounting bracket 400 may include a mounting plate 420, a first support plate 430, and a second support plate 440. The mounting plate 420 is spaced from an outer wall of the housing 200. Two opposite side edges of the mounting plate 420 are respectively fixedly connected to one end of the first support plate 430 and one end of the second support plate 440, and the other end of the first support plate 430 and the other end of the second support plate 440 are fixedly connected to the outer wall of the housing 200.

It may be understood that one end that is of the guide post 740 and that is away from the housing 200 may be fixedly connected to the mounting plate 420.

In the example in which the mounting bracket 400 includes the mounting plate 420, the first support plate 430, and the second support plate 440, the first opening 421 used for the second end 510 of the first connector 500 to move is disposed on the mounting plate 420.

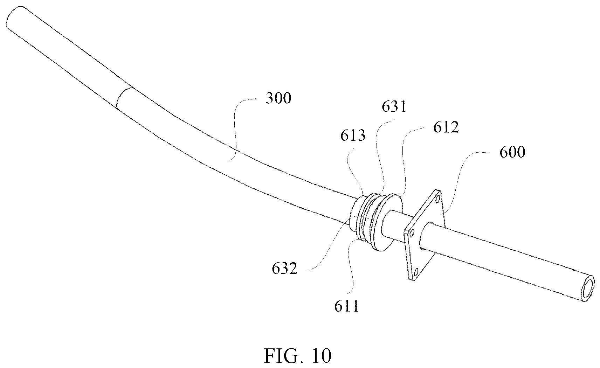

FIG. 9 is an enlarged view of a part A in FIG. 5, that is, an enlarged view of a sealing structure. FIG. 10 is an exploded view of a hose and a sealing structure of an electronic device according to an embodiment of this application.

As shown in FIG. 9 and FIG. 10, in this embodiment of this application, the sealing structure 600 includes a plug 610, and the plug 610 is disposed at the working medium through-flow hole 210. The plug 610 is fixedly connected to the housing 200. The hose 300 penetrates through the plug 610 and is fixedly connected to the plug 610. A joint between the hose 300 and the plug 610 is sealed, and the plug 610 seals a gap between the hose and the housing.

It may be understood that the plug 610 may be disposed on the outer side of the housing 200, or may be embedded in the working medium through-flow hole 210. When the plug 610 is disposed on the outer side of the housing 200, sealing between the plug 610 and the outer wall of the housing 200 may be implemented. When the plug 610 is embedded in the working medium through-flow hole 210, sealing between the plug 610 and a hole wall of the working medium through-flow hole 210 may be implemented.

It should be noted that a seal may be disposed between the plug 610 and the housing 200, and the gap between the housing 200 and the hose 300 is sealed by using the plug 610 and the seal. Alternatively, a shape and a size of the plug 610 may be adjusted, so that an outer wall of the plug 610 is tightly attached to the housing to implement sealing, and the gap between the housing 200 and the hose 300 is directly sealed by using the plug 610.

For example, the plug 610 may be made of epoxy resin or another polymer material, and the hose 300 may be a plastic pipe.

In this way, the gap between the working medium through-flow hole 210 of the housing 200 and the hose 300 is sealed by using the plug 610. A cooling working medium in the housing 200 does not easily leak through the working medium through-flow hole 210. The plug 610 at the working medium through-flow hole 210 and the hose 300 are highly integrated and occupy a small space. Therefore, the plug 610 and the hose 300 are simply assembled with the housing 200, sealing is convenient, and the electronic device 111 is easy to manufacture.

In this embodiment of this application, the plug 610 may be bonded and fastened to the hose 300 by using a sealant, and the sealant seals the joint between the hose 300 and the plug 610.

In this way, the plug 610 and the hose 300 are easily fastened, and manufacturing costs are low.

In this embodiment of this application, the plug 610 and the hose 300 may be of an integrated structure.

In this way, the plug 610 is firmly fastened to the hose 300, and sealing performance between the plug 610 and the hose 300 is good. After the plug 610 and the hose 300 are assembled to the working medium through-flow hole 210, the cooling working medium is not easily leaked from a connection part between the hose 300 and the plug 610. In addition, assembly and sealing efficiency among the hose 300, the plug 610, and the housing 200 may be further improved. In this way, assembly and sealing among the hose 300, the plug 610, and the housing 200 are more convenient.

It may be understood that the plug 610 and the hose 300 may be integrated in an injection molding manner.

In this embodiment of this application, a cross section of the working medium through-flow hole 210 in a direction perpendicular to the axial direction of the working medium through-flow hole 210 may be circular, and a cross section of the plug 610 in a direction perpendicular to an axial direction of the plug 610 may be a circular ring. In this way, a larger sealing surface is formed between the plug 610 and the housing 200. This is conducive to improving a sealing effect.

Certainly, in some examples, the cross section of the working medium through-flow hole 210 in the direction perpendicular to the axial direction of the working medium through-flow hole 210 may be a square or another polygon, and an outer edge of the cross section of the plug 610 in the direction perpendicular to the axial direction of the plug 610 is a corresponding square or another polygon.

In this embodiment of this application, the plug 610 is at least partially embedded in the working medium through-flow hole 210, and a part that is of the plug 610 and that is embedded in the working medium through-flow hole 210 seals the gap between the hose 300 and the hole wall of the working medium through-flow hole 210.

Specifically, the plug 610 includes a plugging part 611, the plugging part 611 extends into the working medium through-flow hole 210, the hose 300 penetrates through the plugging part 611 and is fixedly connected to the plugging part 611, a joint between the hose 300 and the plugging part 611 is sealed, and the plugging part 611 seals the gap between the hose 300 and the hole wall of the working medium through-flow hole 210.

In this way, a structure that protrudes outside the housing 200 can be reduced. Overall space performance obtained after the housing 200 and the plug 610 are assembled is better. In addition, a sealing surface between the plug 610 and the housing 200 is enlarged. This is conducive to improving a sealing effect between the plug 610 and the housing 200.

In this embodiment of this application, the hole wall of the working medium through-flow hole 210 has a step structure, and the plugging part 611 abuts against the step structure of the working medium through-flow hole 210, to limit movement of the plugging part 611 towards a direction of an inner cavity of the housing 200.

In this way, a position of the plug 610 in the working medium through-flow hole can be limited by using the step structure of the working medium through-flow hole 210, and a risk that the plug 610 slides into the housing 200 can be reduced, so that the plug 610 and the housing 200 are more easily assembled and firmer after assembly. The step structure on the hole wall of the working medium through-flow hole 210 is also conducive to enlarging the sealing surface between the plugging part 611 and the hole wall of the working medium through-flow hole 210, to improve sealing performance.

It should be noted that the plugging part 611 may be of a step structure having one or more step surfaces. When the plugging part 611 is of a step structure with a plurality of step surfaces, the step structure of the working medium through-flow hole 210 may fit with the plugging part 611 to form a structure in which a plurality of step surfaces abut against each other. In this way, the sealing surface between the plugging part 611 and the working medium through-flow hole 210 can be enlarged. This is conducive to improving the sealing effect.

It may be understood that the step structure of the working medium through-flow hole 210 has a first vertical end face and a first horizontal sidewall, the plugging part 611 has a second vertical end face and a second horizontal sidewall, the first vertical end face and the second vertical end face are perpendicular to the axial direction of the working medium through-flow hole 210, and the first horizontal sidewall and the second horizontal sidewall are parallel to the axial direction of the working medium through-flow hole 210.

The second vertical end face that is of the plugging part 611 and that faces the inner cavity of the housing 200 abuts against the first vertical end face of the working medium through-flow hole 210.

The plugging part 611 may have two, three, four, or more second vertical end faces that face the inner cavity of the housing 200.

In this embodiment of this application, the sealing structure 600 further includes a sealing gasket 631 disposed between at least one first vertical end face of the working medium through-flow hole 210 and the plugging part 611. The first vertical end face at the sealing gasket 631 abuts against the plugging part 611 by using the sealing gasket 631, and the sealing gasket 631 seals a gap between the first vertical end face at the sealing gasket 631 and the plugging part 611, so that the plugging part 611 seals the gap between the hose 300 and the hole wall of the working medium through-flow hole 210.

Specifically, the sealing gasket 631 is compressed by the plugging part 611 and the first vertical end face of the working medium through-flow hole 210 at two ends, to seal the gap between the first vertical end face at the sealing gasket 631 and the plugging part 611.

In this way, sealing between the plug 610 and the working medium through-flow hole 210 can be implemented by using the sealing gasket 631 tightly clamped by the first vertical end face of the working medium through-flow hole 210 and the plugging part 611, so that the precision requirements for a shape and a size of the plug 610 can be reduced, and a sealing effect between the plug 610 and the working medium through-flow hole 210 is good. In addition, the sealing gasket 631 is easy to assemble, and assembly efficiency among the plug 610, the sealing gasket 631, and the housing 200 is high.

It may be understood that the sealing gasket 631 may be disposed only between one first vertical end face of the working medium through-flow hole 210 and the plugging part 611. When the plugging part 611 has a plurality of second vertical end faces that face the inner cavity of the housing 200, one or more sealing gaskets 631 may alternatively be separately disposed between the plurality of second vertical end faces that are of the plugging part 611 and that face the inner cavity of the housing 200 and corresponding first vertical end faces of the working medium through-flow hole 210.

In this embodiment of this application, the sealing structure 600 further includes a sealing ring 632 disposed between at least one first horizontal sidewall of the working medium through-flow hole 210 and the plugging part 611, and the sealing ring 632 seals a gap between the first horizontal sidewall at the sealing ring 632 and the plugging part 611, so that the plugging part 611 seals the gap between the hose 300 and the hole wall of the working medium through-flow hole 210.

Specifically, the sealing ring 632 is compressed by the plugging part 611 and the first horizontal sidewall of the working medium through-flow hole 210 on two sides, to seal the gap between the first horizontal sidewall at the sealing ring 632 and the plugging part 611.

In this way, sealing between the plug 610 and the working medium through-flow hole 210 can be implemented by using the sealing ring 632 compressed by the first horizontal sidewall of the working medium through-flow hole 210 and the plugging part 611, so that the precision requirements for a shape and a size of the plug 610 can be reduced, and a sealing effect between the plug 610 and the working medium through-flow hole 210 is good. In addition, after the sealing ring 632 is assembled, the sealing performance is less affected by axial movement of the plugging part 611, and the sealing performance is stable.

It may be understood that the sealing ring 632 may be disposed only between one first horizontal sidewall of the working medium through-flow hole 210 and the plugging part 611. When the plugging part 611 has a plurality of second horizontal sidewalls, one or more sealing rings 632 may alternatively be separately disposed between the plurality of second horizontal sidewalls of the plugging part 611 and corresponding first horizontal sidewalls of the working medium through-flow hole 210.

In this embodiment of this application, an annular sealing groove is disposed on an outer wall of the plugging part 611, the sealing ring 632 is mounted in the annular sealing groove, and the sealing ring 632 is compressed by the first horizontal sidewall of the working medium through-flow hole 210 and a groove wall of the annular sealing groove.

In this way, the sealing ring 632 is conveniently assembled, a risk that the sealing ring 632 displaces can be reduced, and the sealing effect is more stable.

It may be understood that the sealing structure 600 may include the sealing ring 632 disposed between the first horizontal sidewall of the working medium through-flow hole 210 and the plugging part 611, but does not include the sealing gasket 631 disposed between the plugging part 611 and the first vertical end face of the working medium through-flow hole 210; may include the sealing gasket 631 disposed between the plugging part 611 and the first vertical end face of the working medium through-flow hole 210, but does not include the sealing ring 632 disposed between the first horizontal sidewall of the working medium through-flow hole 210 and the plugging part 611; or may include both the sealing gasket 631 disposed between the plugging part 611 and the first vertical end face of the working medium through-flow hole 210 and the sealing ring 632 disposed between the first horizontal sidewall of the working medium through-flow hole 210 and the plugging part 611.

In this embodiment of this application, the sealing structure 600 includes the sealing gasket 631 disposed between the plugging part 611 and the first vertical end face of the working medium through-flow hole 210 and the sealing ring 632 disposed between the first horizontal sidewall of the working medium through-flow hole 210 and the plugging part 611. In this way, the sealing effect between the plug 610 and the working medium through-flow hole 210 is better.

In this embodiment of this application, the plug 610 further includes a limiting part 612 disposed on the outer wall of the plugging part 611, the hose 300 penetrates through the limiting part 612 and is fixedly connected to the limiting part 612, and a joint between the hose 300 and the limiting part 612 is sealed.

An end face that is of the limiting part 612 and that faces the inner cavity of the housing 200 abuts against the housing 200, to limit movement of the plugging part 611 towards the direction of the inner cavity of the housing 200.

In this way, a position of the plugging part 611 in the working medium through-flow hole 210 can be limited by using the limiting part 612, thereby reducing a risk that the sealing gasket 631 or the hole wall of the working medium through-flow hole 210 is overcompressed by the plugging part 611 or the plug 611 slides into the housing 200.

For example, the limiting part 612 is a limiting ring around a circumference of the plugging part 611. In this way, the limiting part 612 firmly abuts against the housing 200, and the plugging part 611 does not easily shake.

In a possible embodiment, the limiting part 612 extends into the working medium through-flow hole 210, the hole wall of the working medium through-flow hole 210 has a fitting part that fits with the limiting part 612, and the limiting part 612 abuts against the fitting part, to limit movement of the plugging part 612 towards the direction of the inner cavity of the housing 200.

It may be understood that the fitting part may be of a table-shape structure, a ring-shaped structure, or the like that is disposed on the hole wall of the working medium through-flow hole 210.

When the hole wall of the working medium through-flow hole 210 has the step structure, the fitting part may be one first vertical end face on the step structure of the working medium through-flow hole 210.

In this way, the limiting part 612 does not need to abut against the outer wall of the housing 200, and a limitation on a shape of the outer wall of the housing 200 can be lowered. A part that is of the outer wall of the housing 200 and that is around the working medium through-flow hole 210 may be in any shape, for example, may be an arc surface.

In this embodiment of this application, the limiting part 612 is disposed on one end that is of the plugging part 611 and that faces away from the inner cavity of the housing 200, and an end face that is of the limiting part 612 and that faces away from the inner cavity of the housing 200 is coplanar with an end face of the end that is of the plugging part 611 and that faces away from the inner cavity of the housing 200.

In this way, when the plugging part 611 and the limiting part 612 are compressed and fastened to the housing 200 by using a compression member, a surface bearing a compressional force is large, and compression is more stable. In addition, the limiting part 612 and the plugging part 611 are also easier to manufacture. In addition, a limitation on some activities of the hose 300 on the outer side of the housing 200 is also lowered.

It may be understood that the end face that is of the limiting part 612 and that faces away from the inner cavity of the housing 200 and the end face of the end that is of the plugging part 611 and that faces away from the inner cavity of the housing 200 may j ointly form a compression surface that compresses and fastens the plug 610 and the housing 200.

In this embodiment of this application, the plug 610 further includes a guide part 613, the guide part 613 is disposed coaxially with the plugging part 611, one end that is of the plugging part 611 and that faces the inner cavity of the housing 200 is fixedly connected to one end of the guide part 613, and the other end of the guide part 613 extends into the housing 200 through the working medium through-flow hole 210. The hose 300 penetrates through the guide part 613 and is fixedly connected to the guide part 613, and a joint between the hose 300 and the guide part 613 is sealed.

In this way, the guide part 613 can limit movement of the hose 300 covered by the guide part 613, and a risk of damage caused by random swinging of the hose 300 at the working medium through-flow hole 210 can be reduced.

In this embodiment of this application, the guide part 613 is in clearance fit with the working medium through-flow hole 210.

In this way, the guide part 613 may play a positioning role, to facilitate assembly of the plug 610, and the plug 610 is more stable after being assembled to the housing 200.

In this embodiment of this application, the end that is of the plug 610 and that faces away from the inner cavity of the housing 200 is located in the working medium through-flow hole 210.

In this way, the structure that protrudes outside the housing 200 can be reduced, and the overall spatial performance obtained after the housing 200 and the plug 610 are assembled is better.

In this embodiment of this application, the plug 610 may be disposed on the outer side of the housing 200, the sealing gasket is disposed between an end face that is of the plug 610 and that faces the inner cavity of the housing 200 and the outer wall of the housing 200, and the sealing gasket is configured to seal a gap between the end face that is of the plug 610 and that faces the inner cavity of the housing 200 and one end that is of the working medium through-flow hole 210 and that faces away from the inner cavity of the housing 200.

In the electronic device 111 provided in this embodiment of this application, the sealing structure 600 further includes a compression flange 620, the compression flange 620 is fixedly connected to the outer wall of the housing 200 by using a fastener, and the compression flange 620 abuts against the end face of the end that is of the plug 610 and that faces away from the inner cavity of the housing 200, to compress and fasten the plug 610 to the housing 200.

In this way, mounting between the plug 610 and the housing 200 is convenient.

It may be understood that the compression flange 620 may be connected to the housing 200 in a non-detachable manner by using a rivet or another fastener, or may be connected to the housing 200 in a detachable manner by using a bolt or another fastener.

The compression flange 620 may abut against the end face of the end that is of the plugging part 611 and that faces away from the inner cavity of the housing 200, that is, the end face of the end that is of the plugging part 611 and that faces away from the inner cavity of the housing 200 may be used as the end face of the end that is of the plug 610 and that faces away from the inner cavity of the housing 200.

In this embodiment of this application, the compression flange 620 may include a base plate part 621 and a boss part 622 protruding from a surface of the base plate part 621, the base plate part 621 is fixedly connected to the outer wall of the housing 200 by using a fastener, the boss part 622 extends into the working medium through-flow hole 210 and abuts against the end face of the end that is of the plug 610 and that faces away from the inner cavity of the housing 200, to compress and fasten the plug 610 to the hole wall of the working medium through-flow hole 210.

It may be understood that the boss part 622 may abut against an end face of the plugging part 611 and/or the limiting part 612, to compress the limiting part 612 on the fitting part or compress the plugging part 611 on the step structure of the working medium through-flow hole 210.

In this way, the compression flange 620 firmly abuts against the plug 610 and can be used to lower a limitation on a shape of the base plate part 621 fixedly connected to the housing 200, and the base plate part 621 can be in any shape, for example, a flat plate shape or a bent plate shape.

In this embodiment of this application, the compression flange 620 is connected to the housing 200 by using a fastener in a detachable manner.

In this way, the plug 610 and the hose 300 are disassembled and assembled conveniently, and maintenance and replacement of the plug 610 and the hose 300 are convenient.

In this embodiment of this application, the fastener that fixedly connects the compression flange 620 and the housing 200 is a threaded fastener that is threaded to the housing 200. In this way, the plug 610 and the housing 200 are disassembled and assembled conveniently, and it is conducive to adjusting a compressional force applied by the compression flange 620 to the plug 610.

It may be understood that the threaded fastener may be a screw, a bolt, a stud, or the like.

In this embodiment of this application, the plug 610 is fixedly connected to the hole wall of the working medium through-flow hole 210 and/or the outer wall of the housing 200 by using a sealant, and the sealant seals a gap between a sidewall of the plug 610 and the housing 200.

In this way, the sealant can be used to fasten the plug 610 at the working medium through-flow hole 210, and can seal a gap between the plug 610 and the working medium through-flow hole 210, thereby reducing a quantity of accessories.

In some examples, the sealing structure 600 may also include a sealing plate, the hose 300 penetrates through the sealing plate, the hose 300 is fixedly connected to the sealing plate, a joint between the hose 300 and the sealing plate is sealed, the sealing plate is fixedly connected to the housing 200, and the sealing plate seals the gap between the hose 300 and the housing 200.

In this embodiment of this application, the inner cavity of the housing 200 is in communication with the first connector 500 through the hose 300. Sealing between the hose 300 and the housing 200 is implemented by using the sealing structure 600. So sealing between the hose 300 and the housing 200 is convenient. The first connector 500 is mounted on the housing 200 by using the floating structure 700 on the mounting bracket 400. The first connector 500 is movable relative to the housing 200. A part that is of the hose 300 and that is between the housing 200 and the floating structure 700 may perform activities such as stretching and bending. The movable hose 300 between the floating structure 700 and the housing 200 has a long length. In this way, a gap between the floating structure 700 and the housing 200 can be narrowed or a floating amount of the floating structure 700 can be increased, thereby facilitating arrangement of the floating structure 700 and reducing space occupation. In addition, the housing 200 may have a simpler structure and may be easier to manufacture. When the first connector 500 is connected to the corresponding second connector 114 on the working medium cooling system 113, even if a position of the first connector 500 relative to the corresponding second connector 114 on the working medium cooling system 113 deviates, the position of the first connector 500 may also be adjusted by using the floating structure 700, so that the first connector 500 is stably and reliably connected to the corresponding second connector 114. In this way, on a premise of stably and reliably assembling the electronic device 111 and the working medium cooling system 113, sealing of the housing 200 at the working medium through-flow hole 210 is convenient, and a requirement for position precision of the first connector 500 is low. Therefore, a requirement for disposition position precision of the first connector 500 on the electronic device 111 can be reduced, and a requirement for assembly position precision of the electronic device 111 relative to the second connector 114 can be reduced.

In the descriptions of the embodiments of this application, it should be noted that, unless otherwise specified and limited, terms "mount", "connect", and "connection" should be understood in a broad sense. For example, the connection may be a fixed connection, an indirect connection implemented by using an intermediate medium, communication between two elements, or an interaction relationship between two elements. For a person of ordinary skill in the art, specific meanings of the terms in the embodiments of this application may be understood based on a specific situation.

In the embodiments of this application, terms such as "first", "second", "third", and "fourth" (if exists) in the specification, the claims, and the accompanying drawings are intended to distinguish between similar objects but do not necessarily indicate a specific order or sequence.

Finally, it should be noted that, the foregoing embodiments are merely intended for describing but not limiting the technical solutions of the embodiments of this application. Although the embodiments of this application are described in detail with reference to the foregoing embodiments, a person of ordinary skill in the art should understand that he/she may still make modifications to the technical solutions described in the foregoing embodiments or make equivalent replacements to some or all technical features thereof, and these modifications or replacements do not make the essence of the corresponding technical solutions depart from the scope of the embodiment technical solutions of the embodiments of this application.

## Claims

1. An electronic device, comprising a housing, a hose, a mounting bracket, a sealing structure, a floating structure, and a first connector, wherein
a working medium through-flow hole is disposed on the housing, one end of the hose is located in the housing through the working medium through-flow hole, and the other end of the hose is located outside the housing and is in communication with the first connector;
the hose is fixedly connected to the housing at the working medium through-flow hole by using the sealing structure, and the sealing structure seals a gap between the hose and the housing;
the mounting bracket is located on an outer side of the housing, one end of the mounting bracket is fixedly connected to the housing, the floating structure is mounted on the other end of the mounting bracket, and the first connector is mounted on the floating structure; and
the floating structure is movably connected to the mounting bracket, and/or the first connector is movably connected to the floating structure.

2. The electronic device according to claim 1, wherein the sealing structure comprises a plug, the plug is disposed at the working medium through-flow hole, the plug is fixedly connected to the housing, the hose penetrates through the plug and is fixedly connected to the plug, a joint between the hose and the plug is sealed, and the plug seals the gap between the hose and the housing.

3. The electronic device according to claim 2, wherein the plug and the hose are of an integrated structure.

4. The electronic device according to claim 2 or 3, wherein the plug comprises a plugging part, the plugging part extends into the working medium through-flow hole, the hose penetrates through the plugging part and is fixedly connected to the plugging part, a joint between the hose and the plugging part is sealed, and the plugging part seals a gap between the hose and a hole wall of the working medium through-flow hole.

5. The electronic device according to claim 4, wherein the hole wall of the working medium through-flow hole has a step structure, and the plugging part abuts against the step structure of the working medium through-flow hole, to limit movement of the plugging part towards a direction of an inner cavity of the housing.

6. The electronic device according to claim 5, wherein the step structure of the working medium through-flow hole has at least one first vertical end face; and
the sealing structure further comprises a sealing gasket disposed between the at least one first vertical end face and the plugging part, the first vertical end face at the sealing gasket abuts against the plugging part by using the sealing gasket, and the sealing gasket seals a gap between the first vertical end face at the sealing gasket and the plugging part, so that the plugging part seals the gap between the hose and the hole wall of the working medium through-flow hole.

7. The electronic device according to claim 5 or 6, wherein the step structure of the working medium through-flow hole has at least one first horizontal sidewall; and
the sealing structure further comprises a sealing ring disposed between the at least one first horizontal sidewall and the plugging part, and the sealing ring seals a gap between the first horizontal sidewall at the sealing ring and the plugging part, so that the plugging part seals the gap between the hose and the hole wall of the working medium through-flow hole.

8. The electronic device according to any one of claims 4 to 7, wherein the plug further comprises a limiting part disposed on an outer wall of the plugging part, the hose penetrates through the limiting part and is fixedly connected to the limiting part, and a joint between the hose and the limiting part is sealed; and
an end face that is of the limiting part and that faces the inner cavity of the housing abuts against the housing, to limit movement of the plugging part towards the direction of the inner cavity of the housing.

9. The electronic device according to any one of claims 4 to 7, wherein the plug further comprises a guide part, the guide part is disposed coaxially with the plugging part, one end that is of the plugging part and that faces the inner cavity of the housing is fixedly connected to one end of the guide part, and the other end of the guide part extends into the housing through the working medium through-flow hole; and
the hose penetrates through the guide part and is fixedly connected to the guide part, and a joint between the hose and the guide part is sealed.

10. The electronic device according to any one of claims 2 to 9, wherein the sealing structure further comprises a compression flange; and
the compression flange is fixedly connected to an outer wall of the housing by using a fastener, and the compression flange abuts against an end face of one end that is of the plug and that faces away from the inner cavity of the housing, to compress and fasten the plug on the housing.

11. The electronic device according to any one of claims 1 to 10, wherein the first connector comprises a first end, a mounting part, and a second end that are in communication with each other, and the mounting part is located between the first end and the second end;
the floating structure comprises a mounting seat and an elastic adjustment sleeve, the mounting seat is mounted on the mounting bracket, a mounting groove is disposed on an end face that is of the mounting seat and that faces away from the housing, a communication hole penetrating through the mounting seat is disposed on a groove wall that is of the mounting groove and that is opposite to a groove opening, the mounting part is disposed in the mounting groove, the first end is connected to the hose, and the second end is configured to connect to a working medium cooling system; and
the elastic adjustment sleeve is disposed between a sidewall of the mounting part and the groove wall of the mounting groove, the mounting part is mounted in the mounting groove through the elastic adjustment sleeve, and the elastic adjustment sleeve is configured to be deformed under the action of an external force, so that a position of the second end changes.

12. The electronic device according to claim 11, wherein a guide post that is oriented in an axial direction of the working medium through-flow hole is fixedly connected to the mounting bracket, a sliding hole that is in sliding engagement with the guide post is disposed on the mounting seat, and the mounting seat is slidably connected to the mounting bracket by using the guide post and the sliding hole; and
an elastic reset member is further disposed between the mounting bracket and the mounting seat, and the elastic reset member is configured to reset the mounting seat.

13. A server, comprising at least one electronic device according to any one of claims 1 to 12.

14. The server according to claim 13, wherein the server further comprises a working medium cooling system;
a second connector that is in a one-to-one correspondence with a first connector of the electronic device is disposed on the working medium cooling system, and the first connector is butt-jointed to the corresponding second connector;
the second connector is in communication with the working medium cooling system; and
the second connector is used by the working medium cooling system to input a cooling working medium to the electronic device through the first connector, or the second connector is used by the electronic device to output a cooling working medium to the working medium cooling system through the first connector.
